# EUROPEAN PATENT SPECIFICATION

(11) **EP 4 572 027 B1**
(45) Date of publication and mention of the grant of the patent: **25.11.2026**
(21) Application number: 24782752.0
(22) Date of filing: 09.09.2024
(51) Int. Cl.: H01R 12/73, H04M 1/02, H05K 1/11, H01R 12/58, H01R 13/24, H01R 24/38, H05K 1/14

(54) **ELECTRONIC DEVICE COMPRISING ELECTRICAL CONNECTION STRUCTURE**
ELEKTRONISCHE VORRICHTUNG MIT ELEKTRISCHER VERBINDUNGSSTRUKTUR
DISPOSITIF ÉLECTRONIQUE COMPRENANT UNE STRUCTURE DE RACCORDEMENT ÉLECTRIQUE

(30) Priority: 13.10.2023 KR 20230136460; 03.11.2023 KR 20230150703
(43) Date of publication of application: 18.06.2025
(73) Proprietor: Samsung Electronics Co., Ltd., Suwon-si, Gyeonggi-do 16677 (KR)
(72) Inventor: CHOI, Sunyong, Suwon-si, Gyeonggi-do 16677 (KR); KIM, Byoungjun, Suwon-si, Gyeonggi-do 16677 (KR); KIM, Sunglak, Suwon-si, Gyeonggi-do 16677 (KR); KIM, Hyunmuk, Suwon-si, Gyeonggi-do 16677 (KR); RYU, Jooyeol, Suwon-si, Gyeonggi-do 16677 (KR); YOON, Shinhyuk, Suwon-si, Gyeonggi-do 16677 (KR); JANG, Gyudae, Suwon-si, Gyeonggi-do 16677 (KR); JUN, Jaeyoung, Suwon-si, Gyeonggi-do 16677 (KR); CHOI, Jinwook, Suwon-si, Gyeonggi-do 16677 (KR); CHOI, Junyoung, Suwon-si, Gyeonggi-do 16677 (KR)
(74) Representative: Gulde & Partner
(86) International application number: PCT/KR2024/013646
(87) International publication number: WO 2025/079876

(56) References cited:
- WO-A1-2009/156801
- WO-A1-99/23722
- JP-A- H08 162 187
- KR-A- 20200 125 725
- US-A- 4 838 800
- US-A1- 2006 046 532

## Description

### [Technical Field]

Embodiments of the disclosure relate to an electronic device including an electrical connection structure.

### [Background Art]

An electronic device may include a plurality of electrical components.The electrical components included in the electronic device may be arranged to be spaced apart from each other at a predetermined interval within the electronic device. Such a spaced arrangement may be provided due to a design structure between respective accessories in the electronic device, or may be provided in order to prevent the performance of counterpart accessories from being degraded due to noise generated from each accessory.

A separate electrical connection structure may be required for electrical connection between at least two electrical components described above. This electrical connection structure needs to be designed in consideration of slimming of the electronic device.

The above information may be provided as a related art for the purpose of helping understanding of the disclosure.No claim or determination is made as to whether any of the foregoing may be applied as prior art with respect to the disclosure.

### [Disclosure of Invention]

### [Technical Problem]

An electronic device may include an electrical connection member (e.g., a third board or connection board) electrically interconnecting a first electrical component (e.g., a first board or main board) and a second electrical component (e.g., a second board or sub-board) disposed in the inner space to be spaced apart from each other. The electrical connection member may include a cable (e.g., a flexible printed circuit board (FPCB)) with a predetermined length, and when a connector structure (e.g., a plug) provided at an end of the cable is physically connected to a socket structure (e.g., a receptacle) disposed on a counterpart electrical component, the two electrical components may be electrically connected to each other.

For example, the socket structure may be disposed to protrude from the outer surface of the board at a predetermined height, and the connector structure may be disposed to protrude from the counterpart board.Accordingly, when the board and the counterpart board need to be electrically connected to each other, the board and the counterpart board may be brought into physical contact with each other by coupling the connector structure to the socket structure.

However, it is necessary to take a significant height and/or width into consideration in the electrical connection structure provided through the socket structure protruding from the board and the connector structure coupled to the socket structure, which may work against slimming of the electronic device or reduce the efficiency of arrangement of surrounding electrical components and/or structures.In addition, the coupling force between the socket structure and the connector structure may cause connection failures such as loose insertion when there is an external impact such as a drop.

US 4 838 800 A and WO 99/23722 A1 disclose conventional devices.

### [Solution to Problem]

The present invention is set out in the appended set of claims.

Various embodiments of the disclosure may provide an electronic device including an electrical connection structure that is capable of helping slim the electronic device.

Various embodiments may provide an electronic device including an electrical connection structure that is capable of helping efficiently arrange surrounding electrical components and/or structures.

Various embodiments may provide an electronic device including an electrical connection structure with a stable coupling force that is capable of helping reduce separation and loose insertion even with an external impact.

However, the problems to be solved in the disclosure are not limited to the above-mentioned problems, and may be variously expanded without departing from the scope of the disclosure.

According to various embodiments, an electronic device may include a first printed circuit board including at least one through hole and at least one conductive pad disposed on an inner surface of the through hole, a second printed circuit board disposed to be electrically connected to the first printed circuit board, and a connector structure disposed to electrically interconnect the first printed circuit board and the second printed circuit board. The connector structure may include a connector header, a connector body extending from the connector header and inserted into the through hole of the first printed circuit board, and at least one contact pin disposed on the connector header. The at least one contact pin may be configured to be electrically connected to the at least one conductive pad when the connector structure is inserted into the first printed circuit board.

According to various embodiments, the electrical connection structure may include a socket structure disposed on a board having a first surface and a second surface oriented in a direction opposite to the first surface, and a connector structure configured to be connected to the socket structure. The socket structure may include a through hole extending from the first surface to the second surface and at least one conductive pad disposed on the inner surface of the through hole. The connector structure may include a connector header and at least one contact pin extending from the connector header and having a shape corresponding to that of the at least one conductive pad.When the connector structure is connected to the socket structure, the at least one contact pin may be brought into elastic contact with the at least one conductive pad.

### [Advantageous Effects of Invention]

An electronic device according to exemplary embodiments of the disclosure includes an electrical connection structure including a socket structure including a conductive pad disposed through an inner surface of a through hole provided in a board, and a connector structure coupled to penetrate a through hole of the socket structure, which is capable of helping slim the electronic device and efficiently arrange surrounding structures.In addition, the electrical connection structure includes an elastic fixation structure for stable fixation of the connector structure coupled to the socket structure, which is capable of helping reduce connection failures such as loose insertion due to an external impact.

Various other effects identified directly or indirectly through the disclosure may be provided.

The effects that are capable of being obtained by the disclosure are not limited to those described above, and other effects not described above may be clearly understood by a person ordinarily skilled in the art to which the disclosure belongs based on the following description.

### [Brief Description of Drawings]

In connection with the description of the drawings, the same or similar components may be denoted by the same or similar reference numerals.
FIG. 1 is a front perspective view of an electronic device according to various embodiments of the disclosure.
FIG. 2 is a rear perspective view of the electronic device of FIG. 1 according to various embodiments of the disclosure.
FIG. 3 is an exploded perspective view illustrating the electronic device of FIG. 1 according to various embodiments of the disclosure.
FIG. 4A is a view illustrating the configuration of a first board including a socket structure according to various embodiments of the disclosure.
FIG. 4B is a partial cross-sectional view of the first board according to various embodiments of the disclosure taken along line 4b-4b in FIG. 4A.
FIG. 4C is a schematic view illustrating a process of forming a socket structure according to various embodiments of the disclosure.
FIG. 4D is a view illustrating the configuration of the first board including the socket structure according to various embodiments of the disclosure.
FIG. 5A is a view illustrating the configuration of a first board including a socket structure according to various embodiments of the disclosure.
FIG. 5B is a partial cross-sectional view of the first board according to various embodiments of the disclosure taken along line 5b-5b in FIG. 5A.
FIGS. 6A and 6B are schematic views illustrating a process of forming the socket structure according to various embodiments of the disclosure.
FIG. 7A is a perspective view of a second board including a connector structure according to various embodiments of the disclosure.
FIG. 7B is a side view of the second board of FIG. 7A according to various embodiments of the disclosure.
FIGS. 7C and 7D are perspective views of the second board including the connector structure according to various embodiments of the disclosure.
FIG. 8 is a perspective view of a second board including a connector structure according to various embodiments of the disclosure.
FIG. 9A is a partial cross-sectional view illustrating the state in which a connector structure is connected to a socket structure according to various embodiments of the disclosure.
FIG. 9B is a side view illustrating the state in which the connector structure is connected to the socket structure according to various embodiments of the disclosure.
FIG. 10A is a perspective view of a connector structure connected to a socket structure according to various embodiments of the disclosure, as viewed from a second surface of the first board.
FIG. 10B is a side view of the first board according to various embodiments of the disclosure taken along line 10b-10b in FIG. 10A.
FIG. 11A is a partial cross-sectional view of an electronic device including an electrical connection structure according to a comparative example.
FIG. 11B is a partial cross-sectional view of an electronic device including an electrical connection structure according to various embodiments of the disclosure.

### [Mode for the Invention]

The following description with reference to the accompanying drawings is provided to assist in a comprehensive understanding of various embodiments of the disclosure as defined by the claims. It includes various specific detail to assist in that understanding but these are to be regarded as merely exemplary. Accordingly, those of ordinary skill in the art will recognize that various changes and modifications of the various embodiments described herein can be made without departing from the scope of the disclosure. In addition, descriptions of well-known functions and configurations may be omitted for clarity and conciseness.

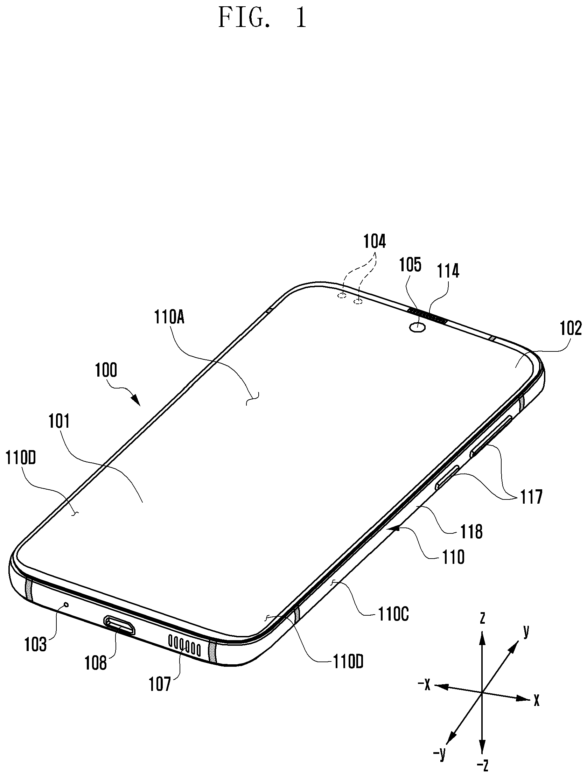

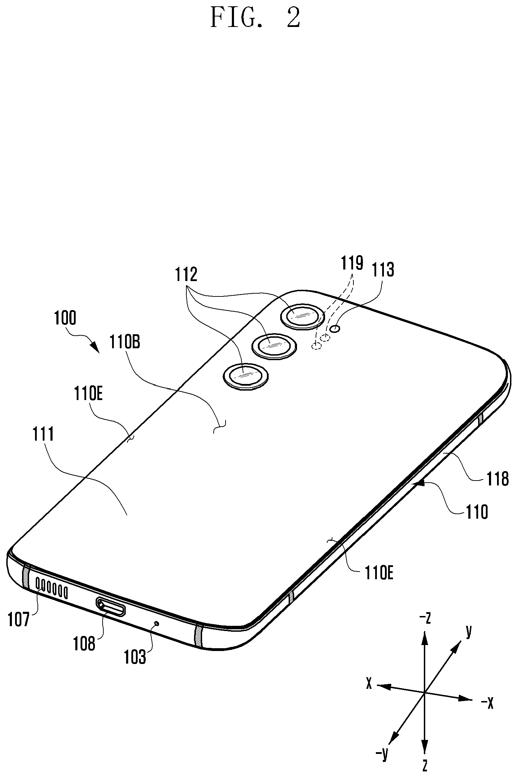

FIG. 1 illustrates a perspective view showing a front surface of a mobile electronic device according to an embodiment of the disclosure, and FIG. 2 illustrates a perspective view showing a rear surface of the mobile electronic device shown in FIG. 1 according to an embodiment of the disclosure.

Referring to FIGS. 1 and 2, a mobile electronic device 100 may include a housing 110 that includes a first surface (or front surface) 110A, a second surface (or rear surface) 110B, and a lateral surface 110C that surrounds a space between the first surface 110A and the second surface 110B. The housing 110 may refer to a structure that forms a part of the first surface 110A, the second surface 110B, and the lateral surface 110C. The first surface 110A may be formed of a front plate 102 (e.g., a glass plate or polymer plate coated with a variety of coating layers) at least a part of which is substantially transparent. The second surface 110B may be formed of a rear plate 111 which is substantially opaque. The rear plate 111 may be formed of, for example, coated or colored glass, ceramic, polymer, metal (e.g., aluminum, stainless steel (STS), or magnesium), or any combination thereof. The lateral surface 110C may be formed of a lateral bezel structure (or "lateral member") 118 which is combined with the front plate 102 and the rear plate 111 and includes a metal and/or polymer. The rear plate 111 and the lateral bezel structure 118 may be integrally formed and may be of the same material (e.g., a metallic material such as aluminum).

The front plate 102 may include two first regions 110D disposed at long edges thereof, respectively, and bent and extended seamlessly from the first surface 110A toward the rear plate 111. Similarly, the rear plate 111 may include two second regions 110E disposed at long edges thereof, respectively, and bent and extended seamlessly from the second surface 110B toward the front plate 102. The front plate 102 (or the rear plate 111) may include only one of the first regions 110D (or of the second regions 110E). The first regions 110D or the second regions 110E may be omitted in part. When viewed from a lateral side of the mobile electronic device 100, the lateral bezel structure 118 may have a first thickness (or width) on a lateral side where the first region 110D or the second region 110E is not included, and may have a second thickness, being less than the first thickness, on another lateral side where the first region 110D or the second region 110E is included.

The mobile electronic device 100 may include at least one of a display 101, audio modules 103, 107 and 114, sensor modules 104 and 119, camera modules 105, 112 and 113, a key input device 117, a light emitting device, and connector hole 108. The mobile electronic device 100 may omit at least one (e.g., the key input device 117 or the light emitting device) of the above components, or may further include other components.

The display 101 may be exposed through a substantial portion of the front plate 102, for example. At least a part of the display 101 may be exposed through the front plate 102 that forms the first surface 110A and the first region 110D of the lateral surface 110C. The display 101 may be combined with, or adjacent to, a touch sensing circuit, a pressure sensor capable of measuring the touch strength (pressure), and/or a digitizer for detecting a stylus pen. At least a part of the sensor modules 104 and 119 and/or at least a part of the key input device 117 may be disposed in the first region 110D and/or the second region 110E.

The audio modules 103, 107 and 114 may correspond to a microphone hole 103 and speaker holes 107 and 114, respectively. The microphone hole 103 may contain a microphone disposed therein for acquiring external sounds and, in a case, contain a plurality of microphones to sense a sound direction. The speaker holes 107 and 114 may be classified into an external speaker hole 107 and a call receiver hole 114. The microphone hole 103 and the speaker holes 107 and 114 may be implemented as a single hole, or a speaker (e.g., a piezo speaker) may be provided without the speaker holes 107 and 114.

The sensor modules 104 and 119 may generate electrical signals or data corresponding to an internal operating state of the mobile electronic device 100 or to an external environmental condition. The sensor modules 104 and 119 may include a first sensor module 104 (e.g., a proximity sensor) and/or a second sensor module (e.g., a fingerprint sensor) disposed on the first surface 110A of the housing 110, and/or a third sensor module 119 (e.g., a heart rate monitor (HRM) sensor) and/or a fourth sensor module (e.g., a fingerprint sensor) disposed on the second surface 110B of the housing 110. The fingerprint sensor may be disposed on the second surface 110B as well as the first surface 110A (e.g., the display 101) of the housing 110. The electronic device 100 may further include at least one of a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 105, 112 and 113 may include a first camera device 105 disposed on the first surface 110A of the electronic device 100, and a second camera device 112 and/or a flash 113 disposed on the second surface 110B. The camera module 105 or the camera module 112 may include one or more lenses, an image sensor, and/or an image signal processor. The flash 113 may include, for example, a light emitting diode or a xenon lamp. Two or more lenses (infrared cameras, wide angle and telephoto lenses) and image sensors may be disposed on one side of the electronic device 100.

The key input device 117 may be disposed on the lateral surface 110C of the housing 110. The mobile electronic device 100 may not include some or all of the key input device 117 described above, and the key input device 117 which is not included may be implemented in another form such as a soft key on the display 101. The key input device 117 may include the sensor module disposed on the second surface 110B of the housing 110.

The light emitting device may be disposed on the first surface 110A of the housing 110. For example, the light emitting device may provide status information of the electronic device 100 in an optical form. The light emitting device may provide a light source associated with the operation of the camera module 105. The light emitting device may include, for example, a light emitting diode (LED), an IR LED, or a xenon lamp.

The connector hole 108 may include a first connector hole 108 adapted for a connector (e.g., a universal serial bus (USB) connector) for transmitting and receiving power and/or data to and from an external electronic device. The connector hole 108 may include a second connector hole (not shown) adapted for a connector (e.g., an earphone jack) for transmitting and receiving an audio signal to and from an external electronic device.

Some sensor modules 105 of camera modules 105 and 212, some sensor modules 104 of sensor modules 104 and 119, or an indicator may be arranged to be exposed through a display 101. For example, the camera module 105, the sensor module 104, or the indicator may be arranged in the internal space of an electronic device 100 so as to be brought into contact with an external environment through an opening of the display 101, which is perforated up to a front plate 102. In another embodiment, some sensor modules 104 may be arranged to perform their functions without being visually exposed through the front plate 102 in the internal space of the electronic device. For example, in this case, an area of the display 101 facing the sensor module may not require a perforated opening.

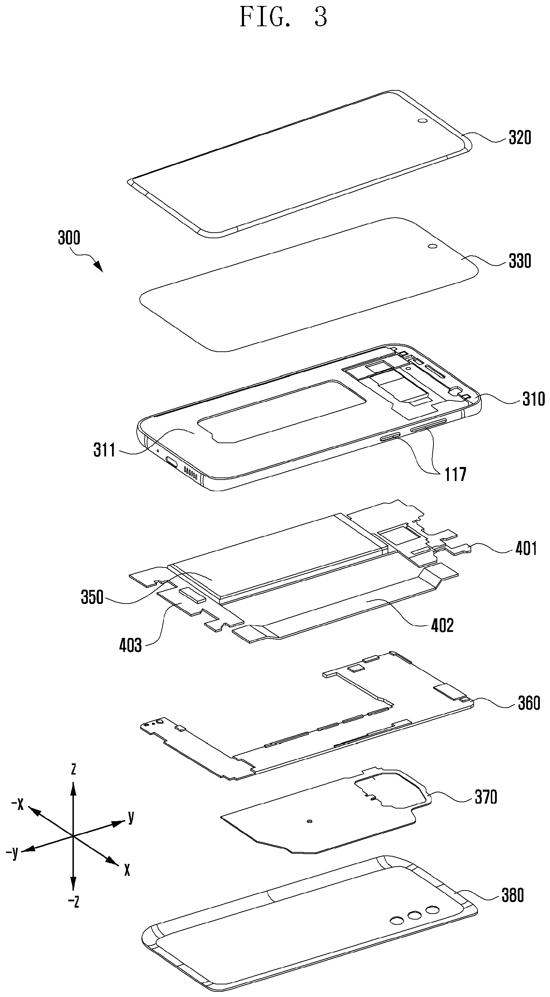

FIG. 3 is an exploded perspective view illustrating the electronic device of FIG. 1 according to various embodiments of the disclosure.

The electronic device 300 of FIG. 3 may include another embodiment of an electronic device that is at least partially similar to or different from the electronic device 100 of FIGS. 1 and 2.

Referring to FIG. 3, the electronic device 300 (e.g., the electronic device 100 of FIG. 1 or 2) may include a side surface member 310 (e.g., a side bezel structure or a side frame), a first support member 311 (e.g., a bracket or a support structure), a front surface cover 320 (e.g., a front surface plate, a first plate, or first cover), a display 330, one or more boards 401, 402, and 403, a battery 350, a second support member 360 (e.g., a rear case, a support structure, or a rear bracket), an antenna 370, and a rear surface cover 380 (e.g., a rear surface plate, a second plate, or a second cover).In some embodiments, in the electronic device 300, at least one of the components (e.g., the first support member 311 or the second support member 360) may be omitted, or other components may be additionally included.At least one of the components of the electronic device 300 may be the same as or similar to at least one of the components of the electronic device 100 of FIG. 1 or FIG. 2, and a redundant description will be omitted below.

The first support member 311 may be disposed inside the electronic device 300 to be connected to the side member 310 or may be formed integrally with the side member 310.The first support member 311 may be made of, for example, a metal material and/or a non-metal material (e.g., polymer).The first support member 311 may have one surface where a display 330 is coupled to one surface and the other surface where one or more boards 401, 402, and 403 are coupled.The one or more boards 401, 402, and 403 may include a first board 401 (e.g., a main board or a first printed circuit board) and a second board 402 (e.g., a connection board, an electrical connection member, or a second printed circuit board), and a third board 403 (e.g., a sub-board or a third printed circuit board).A processor, memory, and/or an interface may be mounted on the first board 401.The processor may include, for example, one or more of a central processing unit, an application processor, a graphics processing unit, an image signal processor, a sensor hub processor, or a communication processor.The first board 401 may be electrically connected to the third board 403 via the second board 402.

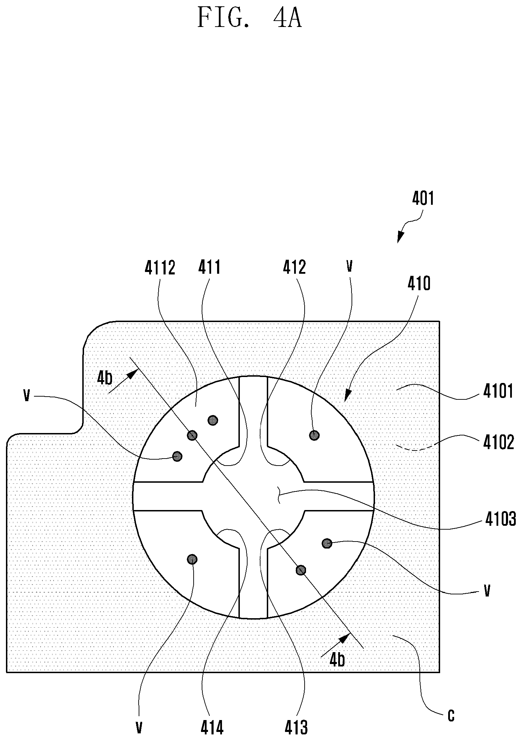

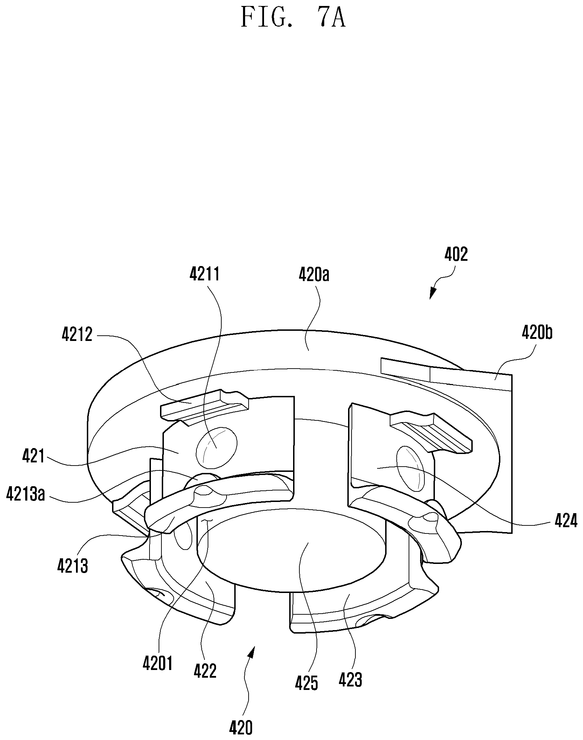

According to an exemplary embodiment of the disclosure, the second board 402 and the first board 401 and/or the second board 402 and the third board 403 may be physically coupled via an electrical connection structure.For example, the electrical connection structure may include a socket structure (e.g., the socket structure 410 in FIG. 4A) disposed on the first board 401 and/or the third board 403 and a connector structure (e.g., connector structure 420 in FIG. 7A) disposed on the second board 402 to be connected to the socket structure.In some embodiments, the socket structure (e.g., the socket structure 410 in FIG. 4A) may be disposed on the second board 402, and the connector structure (e.g., the connector structure 420 in FIG. 7A) may be disposed on the first board 401.

The memory may include, for example, volatile memory or non-volatile memory.

The interface may include, for example, a high-definition multimedia interface (HDMI), a universal serial bus (USB) interface, an SD card interface, and/or an audio interface. For example, the interface may electrically or physically connect the electronic device 300 to an external electronic device, and include a USB connector, an SD card/MMC connector, or an audio connector.

The battery 350 is a device for supplying power to at least one component of the electronic device 300, and may include, for example, a non-rechargeable primary battery, a rechargeable secondary battery, or a fuel cell.At least a portion of the battery 350 may be disposed to be substantially flush with, for example, the board 340.The battery 350 may be integrally arranged inside the electronic device 300.In another embodiment, the battery 350 may be detachably attached to the electronic device 300.

The antenna 370 may be disposed between the rear surface cover 380 and the battery 350.The antenna 370 may include, for example, a near-field communication (NFC) antenna, a wireless charging antenna, and/or a magnetic secure transmission (MST) antenna. For example, the antenna 370 may execute short-range communication with an external device or may transmit/receive power required for charging to/from an external device in a wireless manner.In another embodiment, an antenna structure may be configured with the side surface bezel structure 310 and/or a portion of the first support member 311, or a combination thereof.

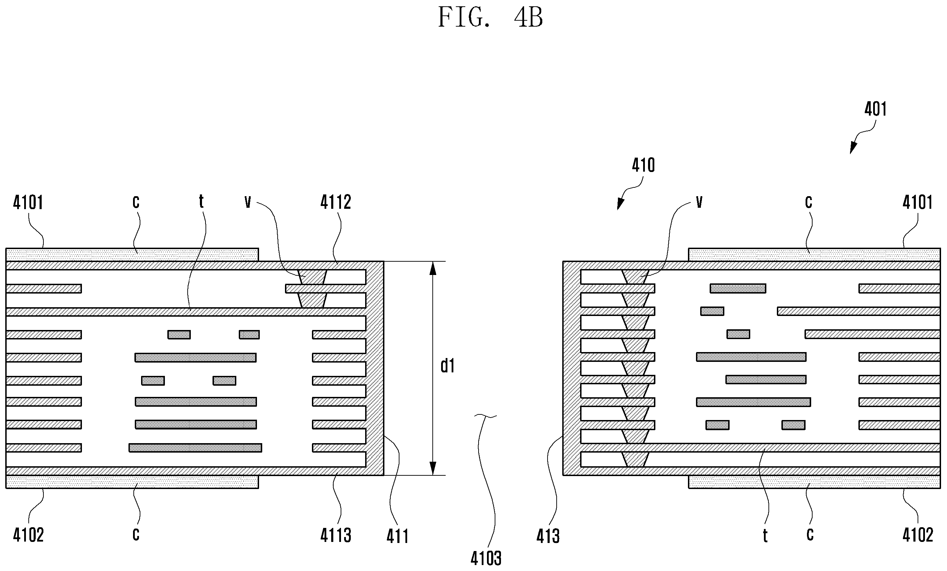

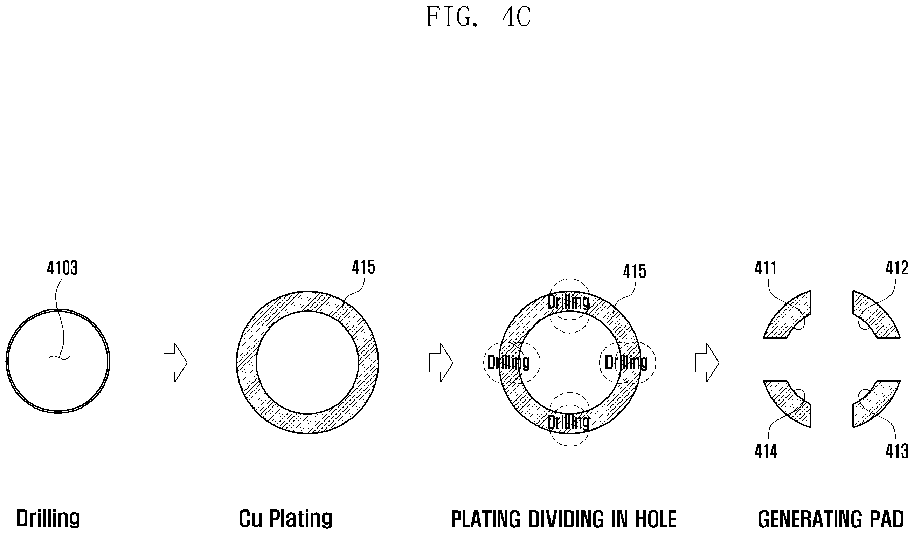

FIG. 4A is a view illustrating the configuration of a first board including a socket structure according to various embodiments of the disclosure.FIG. 4B is a partial cross-sectional view of the first board according to various embodiments of the disclosure taken along line 4b-4b in FIG. 4A.FIG. 4C is a schematic view illustrating a process of forming the socket structure according to various embodiments of the disclosure.

Referring to FIGS. 4A to 4C, the first board 401 (e.g., the first board 401 in FIG. 3) may include a first surface 4101 and a second surface 4102 oriented in the opposite direction to the first surface 4101.In an embodiment, the first board 401 may be formed by stacking a plurality of insulating layers in the space between the first surface 4101 and the second surface 4102.In an embodiment, the first board 401 may include a socket structure 410 (e.g., a receptacle or socket) to be electrically connected to a connector structure (e.g., the connector structure 420 in FIG. 7A) (e.g., a plug or connector) of a second board (e.g., the second board 402 in FIG. 7A).

According to various embodiments, the socket structure 410 may include a through hole 4103 extending from the first surface 4101 to the second surface 4102 of the first board 401 and one or more conductive pads 411, 412, 413, and 414 disposed through the through hole 4103.In an embodiment, the one or more conductive pads 411, 412, 413, and 414 may include a first conductive pad 411, a second conductive pad 412, a third conductive pad 413 and a fourth conductive pad 414 which are arranged on the inner surface of the through hole 4103 at a predetermined interval.

According to various embodiments, the socket structure 410 may include a first extension pad 4112 extending from the first conductive pad 411 to at least a portion of the first surface 4101 of the first board 401, and/or a second extension pad 4113 extending from the first conductive pad 411 to at least a portion of the second surface 4102 of the first board 401.In an embodiment, the vertical distance d1 from the first extension pad 4112 and the second extension pad 4113 may be substantially equal to the depth of the through hole 4103.In an embodiment, the first extension pad 4112 and/or the second extension pad 4113 may be disposed to be exposed to the outside by omitting a cover layer c (e.g., a cover lay) disposed on the first surface 4101 and/or the second surface 4102 of the first board 401.In an embodiment, the cover layer c may include solder resist (SR) layers laminated on the first surface 4101 and the second surface 4102.In an embodiment, the first conductive pad 411, the first extension pad 4112, and/or the second pad 4113 may include a Cu plate (e.g., a Cu plating layer).

According to various embodiments, as illustrated in FIG. 4C, the through hole 4103 may be formed in the first board 401 through drilling.Thereafter, a plating layer 415 may be formed on the inner surface of the through hole 4103 and the first and second surfaces 4101 and 4102 of the board 401.For example, the plating layer 415 may be formed through Cu plating.In an embodiment, the plating layer 415 may be divided into a plurality of conductive pads 411, 412, 413, and 414 arranged to be electrically separated from each other at a predetermined interval through drilling.For example, each of the plurality of conductive pads 411, 412, 413, and 414 may be formed to have an interval of at least 0.2 mm by a bit of a drill, but may be formed to have various intervals without being limited thereto. In an embodiment, the number, shapes, and sizes of the conductive pads 411, 412, 413, and 414 may be determined considering the types of signals (e.g., power or general-purpose input/output (GPIO)) connected thereto via a connector structure (the connector structure 420 of FIG. 7A) to be connected thereto or a fastening structure.The conductive pads may be implemented asymmetrically.

According to various embodiments, the first board 401 may include at least one conductive via v penetrated from the first conductive pad 411 and/or the first extension pad 4112 to a metal layer (e.g., a Cu layer) of a predetermined depth.In an embodiment, the first board 401 may include a trace t (e.g., a wiring structure) formed by at least a portion of the corresponding metal layer.In an embodiment, the first conductive pad 411 and/or the first extension pad 4112 may be electrically connected to the trace t via at least one conductive via v.In an embodiment, the at least one conductive via v may be formed in various numbers. In an embodiment, the number of conductive vias v may be determined depending on whether the first conductive pad 411 transmits signals with different characteristics, such as power or GPIO.In an embodiment, when the first conductive pad 411 is used to connect power, a varying number of conductive vias v may be arranged depending on the allowable amount of current.For example, the number of conductive vias v may be determined considering the content of Cu applied to the conductive vias v.For example, assuming that one conductive via v with a diameter of 0.1 mm is suitable for transmitting a current of 450 mA, 2 to 3 conductive vias v may be applied when power causing a current of 1 A to flow is connected to the first conductive pad 411. For example, the number of conductive vias v may be freely determined depending on the characteristics of the signals connected to the first conductive pad 411.

According to various embodiments, the second conductive pad 412, the third conductive pad 413, and the fourth conductive pad 414 may be formed in substantially the same way as the first conductive pad 411 and the first and second extension pads 4112 and 4113 extending from the first conductive pad 411.In some embodiments, the size or shape of at least one of the first to fourth conductive pads 411, 412, 413, and 414 may be different from the sizes of the remaining conductive pads.

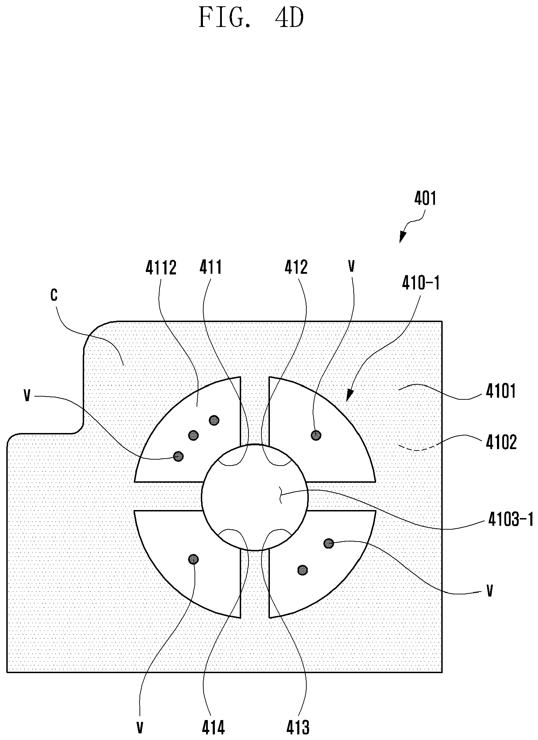

FIG. 4D is a view illustrating the configuration of the first board including the socket structure according to various embodiments of the disclosure.

Referring to FIG. 4D, unlike FIG. 4A, the conductive pads 411, 412, 413, and 414 included in the socket structure 410-1 may be electrically divided through masking and etching processes rather than drilling. For example, the conductive pads 411, 412, 413, and 414 may be formed by forming a Cu plating layer on the inner surface of the through hole 4103-1 and on the first surface 4101 and/or the second surface 4102 of the first board 401 to surround the through hole 4103-1, and removing some of the plating layer through the masking process.In some embodiments, the inner surface of the through hole 4103 may be formed by forming electrically separated conductive pads 411, 412, 413, and 414 first on the inner surface of the through hole 4103-1, then forming a Cu plating layer to surround the through hole 4103-1, and removing some of the plating layer through the masking process.

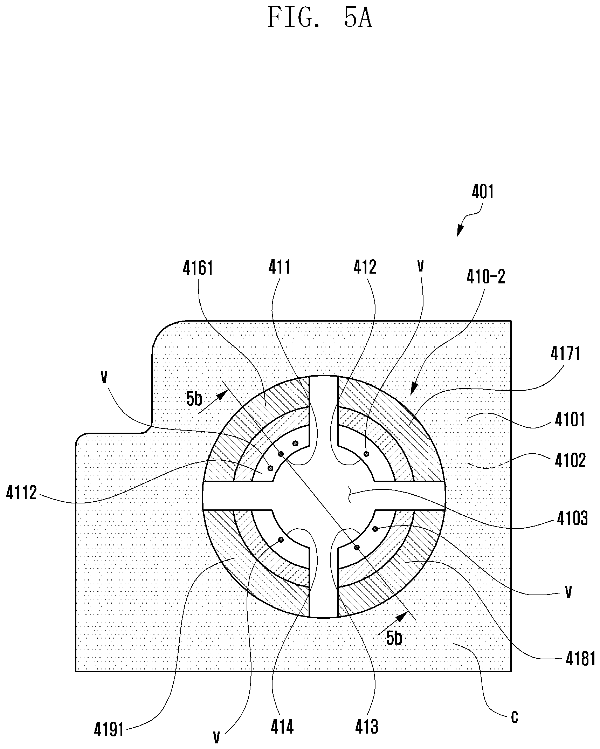

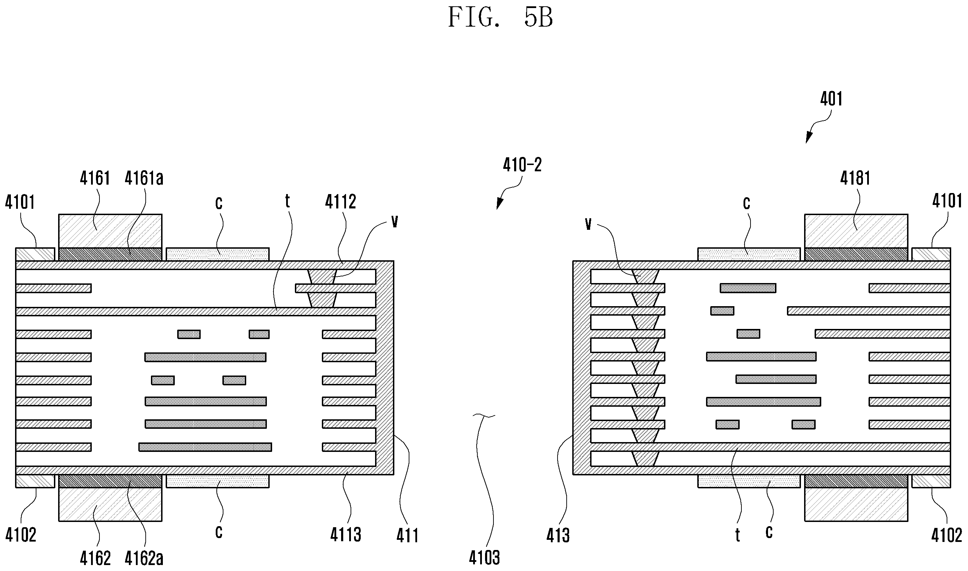

FIG. 5A is a view illustrating the configuration of a first board including a socket structure according to various embodiments of the disclosure.FIG. 5B is a partial cross-sectional view of the first board according to various embodiments of the disclosure taken along line 5b-5b in FIG. 5A.

In describing the socket structure 410-2 of FIGS. 5A and 5B, the same reference numerals are assigned to components that are substantially the same as those of the socket structure 410 of FIG. 4A, and a detailed description thereof may be omitted.

Referring to FIGS. 5A and 5B, the socket structure 410-2 may further include one or more reinforcing members 4161 and 4162 disposed on at least a portion of the first extension pad 4112 and/or the second extension pad 4113.In this case, the one or more reinforcing member 4161 and 4162 may include a first reinforcing member 4161 disposed on the first extension pad 4112 or a second reinforcing member 4162 disposed on the second extension pad 4113.In an embodiment, the first reinforcing member 4161 or the second reinforcing member 4162 may be used as a contact structure which is in contact with a first extensionpin (e.g., the first extension pin 4212 in FIG. 7A) or a second extension pin (e.g., the second extension pin 4213 in FIG. 7A) of a connector structure (e.g., the connector structure 420 in FIG. 7A) connected to the socket structure 410-2, thereby helping prevent damage to the outer surface (e.g., the first surface 4101 or the second surface 4102) of the first board 401 due to the connection of a connector structure.In an embodiment, the first reinforcing member 4161 or the second reinforcing member 4162 may be made of a metal material (e.g., stainless steel) that guarantees strength.In an embodiment, the first reinforcing member 4161 or the second reinforcing member 4162 may be attached to the first extension member 4112 or the second extension member 4113 via a conductive attachment member 4161a or 4162a.For example, a connector structure (e.g., the connector structure 420 in FIG. 7A) may be electrically connected to the first extension pad 4112 or the second extension pad 4113 via the conductive attachment members 4161a and 4162a when the first extension pin (e.g., the first extension pin 4212 in FIG. 7A) or the second extension pin (e.g., the second extension pin 4113 in FIG. 7A) come into contact with the first reinforcing member 4161 or the second reinforcing member 4162.In an embodiment, the conductive attachment members 4161a and 4162a may include a conductive adhesive disposed through conductive bonding, a conductive tape disposed through conductive taping, or solder disposed through soldering.In an embodiment, in the case where solder is applied as the conductive attachment members 4161a and 4162a, when the first surface 4101 or the second surface 4102 of the first board 401 is viewed from above, the first board 401 may further include a cover layer c (e.g., an SR layer) disposed between the first reinforcing member 461 and the through hole 4103 or disposed between the second reinforcing member 462 and the through hole 4103.In an embodiment, the cover layer c may help reduce the phenomenon of free solder overflowing into the through hole 4103 during reflow.

According to various embodiments, the extension pads extending from the second conductive pad 412, the third conductive pad 413, and the fourth conductive pad 414 may also include reinforcing members 4171, 4181, and 4191 which may be disposed thereon in substantially the same manner as the first and second reinforcing members 4161 and 4162 disposed on the first and second extension pads 4112 and 4113 extending from the first conductive pad 411.

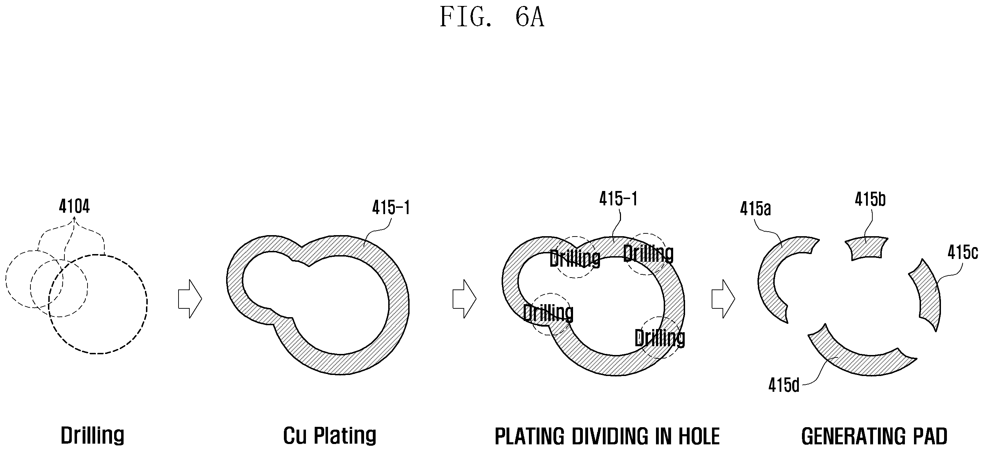

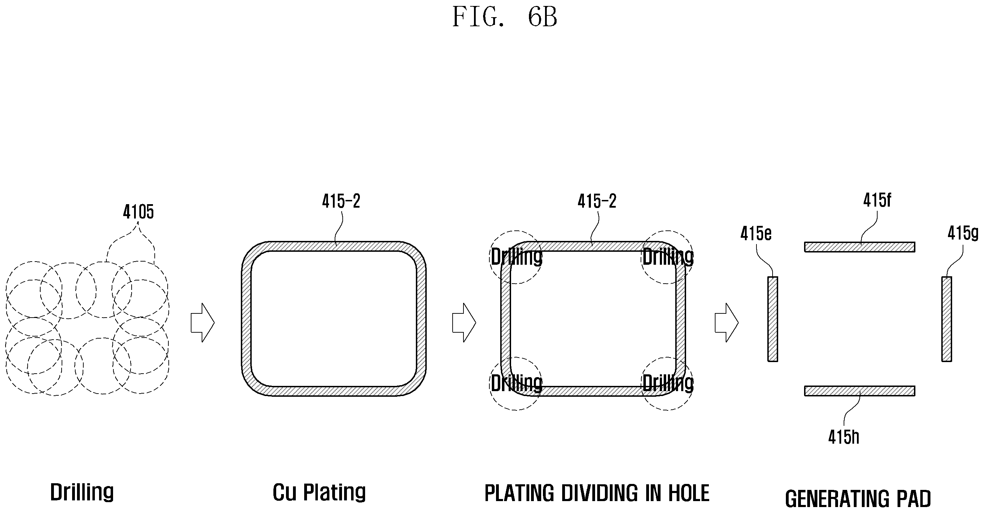

FIGS. 6A and 6B are schematic views illustrating a process of forming the socket structure according to various embodiments of the disclosure.

Referring to FIG. 6A, the through hole 4104 may be formed in an asymmetric shape through multiple drilling operations. Thereafter, a plating layer 415-1 may be formed along the edge of the asymmetric through hole 4104.The plating layer 415-1 may be formed through a Cu plating process.In an embodiment, the plating layer 415-1 may be divided into a plurality of conductive pads 415a, 415b, 415c, and 415d in at least some portions through multiple drilling operations.

Referring to FIG. 6A, the through hole 4105 may be formed in a rectangular shape through multiple drilling operations. Thereafter, a plating layer 415-2 may be formed along the edge of the rectangular through hole 4105.The plating layer 415-2 may be formed through a Cu plating process.In an embodiment, the plating layer 515-2 may be divided into a plurality of conductive pads 415e, 415f, 415g, and 415h formed through multiple drilling operations in at least some portions (e.g., each corner).

For example, the shape of the through hole, the number, arrangement positions, arrangement interval or sizes of the conductive pads in the socket structure 410 may be determined considering at least one of the types of signals (e.g., power or general-purpose input/output (GPIO)) or the effective number of signal lines passing through the connector structure (e.g., the connector structure 420 in FIG. 7A) to be connected to the socket structure 410 and the second board (e.g., the second board 402 in FIG. 7A).

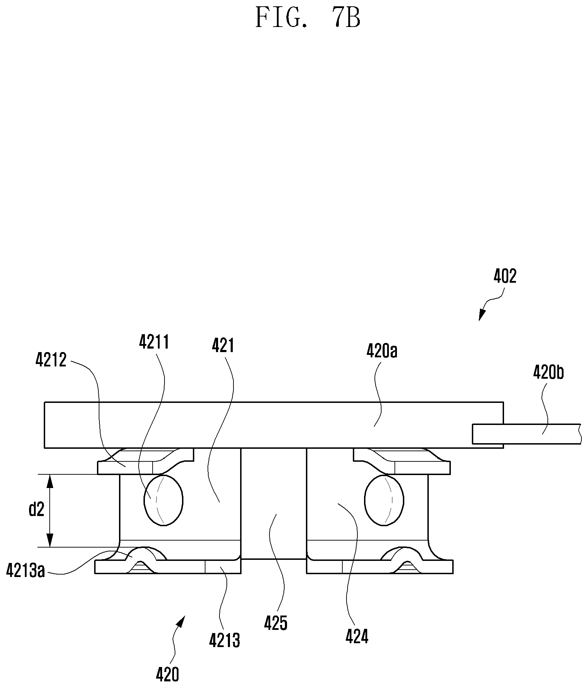

FIG. 7A is a perspective view of a second board including a connector structure according to various embodiments of the disclosure.FIG. 7B is a side view of the second board of FIG. 7A according to various embodiments of the disclosure.

Referring to FIGS. 7A and 7B, the second board 402 may include a flexible printed circuit board (FPCB) 420b and a connector structure 420 disposed on the flexible board 420b.In an embodiment, the flexible board 420b may have a length for connecting a first board (e.g., the first board 401 of FIG. 4A) to a peripheral electrical component (e.g., the third board 403 of FIG. 3).

According to various embodiments, the connector structure 420 may include a connector header 420a disposed at one end and/or each end of the flexible board 420b, and one or more contact pins 421, 422, 423, and 424 extending from the connector header 420a disposed at positions corresponding to the conductive pads (e.g., the conductive pads 411, 412, 413, and 414 in FIG. 4A) of the above-described socket structure (e.g., the socket structure 410 in FIG. 4A).In an embodiment, the one or more contact pins 421, 422, 423, and 424 may include, when the connector structure 420 is connected to the socket structure 410, a first contact pin 421 disposed at a position corresponding to a first conductive pad (e.g., the first conductive pad 411 in FIG. 4A), a second contact pin 422 disposed at a position corresponding to a second conductive pad (e.g., the second conductive pad 412 in FIG. 4A), a third contact pin 423 disposed at a position corresponding to a third conductive pad (e.g., the third conductive pad 413 in FIG. 4A), and a fourth contact pin 424 disposed at a position corresponding to a fourth conductive pad (e.g., the fourth conductive pad 414 in FIG. 4A).In an embodiment, the contact pins 421, 422, 423, and 424 may be made of a metal material (e.g., stainless steel or Cu) that is insert-molded into the connector header 420a formed as an injection-molded product.According to various embodiments, the connector structure 420 may include a non-conductive connector body 425 (e.g., a non-conductive post) disposed between the contact pins 421, 422, 423, and 424 and protruding from the connector head 420a.In an embodiment, the contact pins 421, 422, 423, and 424 may have a predetermined space 4201 with respect to the non-conductive connector body 425 and may be arranged to surround the non-conductive connector body 425.In an embodiment, the space 4201 formed between the non-conductive connector body 425 and the contact pins 421, 422, 423, and 424 may be used as an accommodation space to accommodate elastic deformation of the contact pins 421, 422, 423, and 424 inserted into the through hole (e.g., the through hole 4103 in FIG. 4A) when the connector structure 420 is connected to the socket structure 410.

According to various embodiments, the first contact pin 421 may include an elastic protrusion 4211 protruding from the outer surface.In an embodiment, the elastic protrusion 4211 may be brought into elastic contact with the first conductive pad (e.g., the first conductive pad 411 in FIG. 4B) when the connector structure 420 is connected to the socket structure 410.In an embodiment, a plurality of elastic protrusions 4211 may be formed. For example, the number of elastic protrusions 4211 may be determined based on at least one of the expansion of electrical contact area, the mounting structure, the fastening/unlocking force of the connector structure 420, or the allowable amount of current of signals.

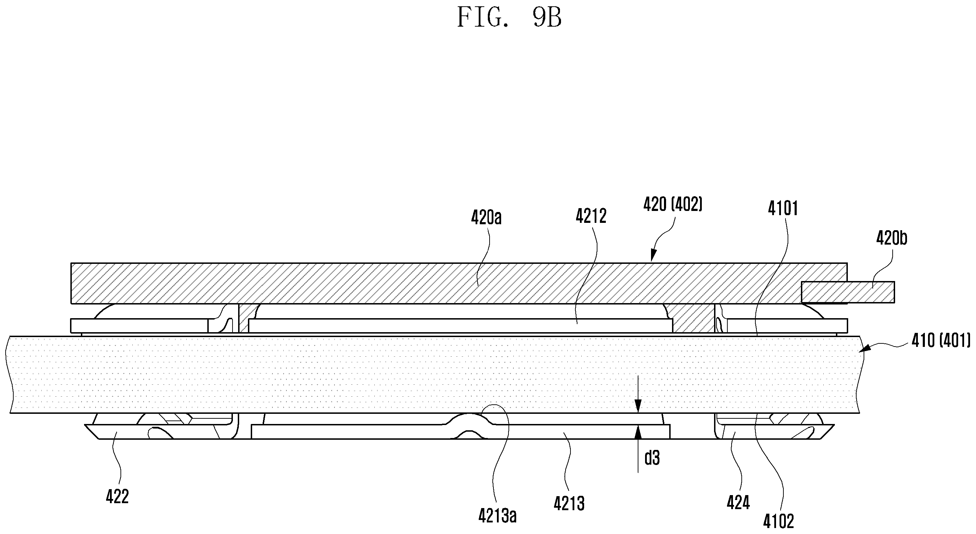

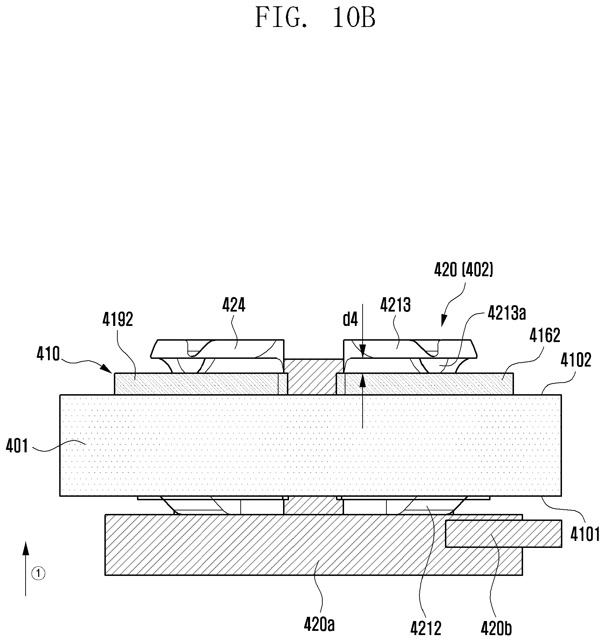

According to various embodiments, the connector structure 420 may include a first extension pin 4212 protruding outward from the first contact pin 421, and a second extension pin 4213 protruding outward from the first contact pin 421 at a position spaced apart from the first extension pin 4212.In an embodiment, the elastic protrusion 4211 may be disposed between the first extension pin 4212 and the second extension pin 4213.In an embodiment, the first extension pin 4212 and/or the second extension pin 4213 may be provided to be elastically deformable in directions away from each other.In an embodiment, the first extension pin 4212 may have a size and/or shape to come into contact with the first extension pad (e.g., the first extension pad 4112 in FIG. 4B) when the connector structure 420 is connected to the socket structure 410.In an embodiment, the second extension pin 4213 may have a size and/or shape to come into contact with the second extension pad (e.g., the second extension pad 4113 in FIG. 4B) when the connector structure 420 is connected to the socket structure 410.In an embodiment, the second extension pin 4213 may include a support protrusion 4213a protruding toward the first extension pin 4212.In an embodiment, the support protrusion 4213a may induce formation of a separation gap (e.g., the separation gap d4 in FIG. 10B) to cause the second extension pin 4213 and the second reinforcing member (e.g., the second reinforcing member 4162 in FIG. 10B) to be partially separated from each other, which may help easily separate the connector structure 420 connected to the socket structure 410 by a separation jig. In some embodiments, when the second reinforcing member 4162 is omitted, the support protrusion 4213a may induce formation of a separation gap (e.g., the separation gap d3 in FIG. 9B) to cause the second extension pin 4213 and the second extension pad (e.g., the second extension pad 4113 in FIG. 4B) to be partially separated from each other, which may help easily separate the connector structure 420 connected to the socket structure410 by a separation jig.

According to various embodiments, the distance d2 between the first extension pin 4212 and the second extension pin 4213 may be smaller than the vertical distance (e.g., the vertical distance d1 in FIG. 4B) between the first extension pad (e.g., the first extension pad 4112 in FIG. 4B) and the second extension pad (e.g., the second extension pad 4113 in FIG. 4B).With this configuration, when the connector structure 420 is connected to the socket structure 410, the first and second extension pins 4212 and 4213 are brought into tight contact with the first and second extension pads (e.g., the extension pads 4112 and 4113 in FIG. 4B) through elastic deformation, which may help improve the fixing force to reduce the phenomenon of the connector structure 420 being separated from the socket structure 420 due to an external impact.

According to various embodiments, the second contact pin 422, the third contact pin 423, and the fourth contact pin 424 may also be formed in the same way as the first contact pin and the first and second extension pins 4212 and 4213 extending from the first contact pin.

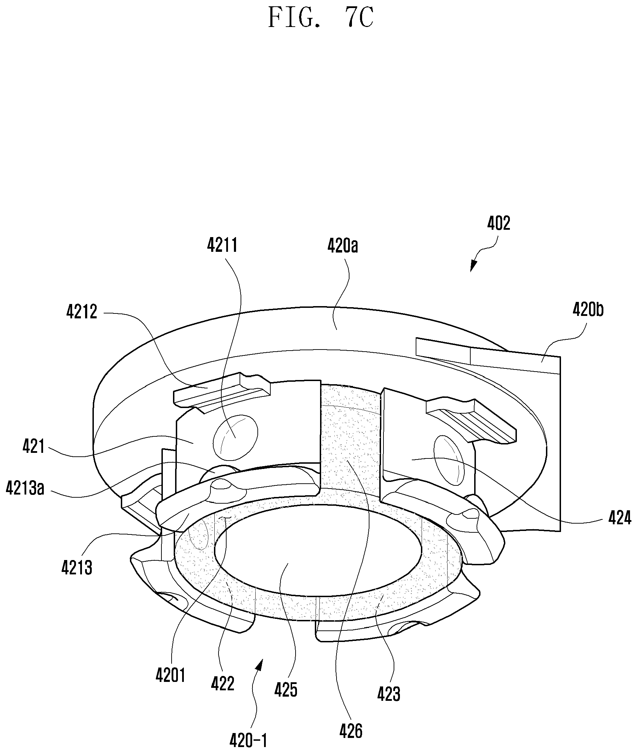

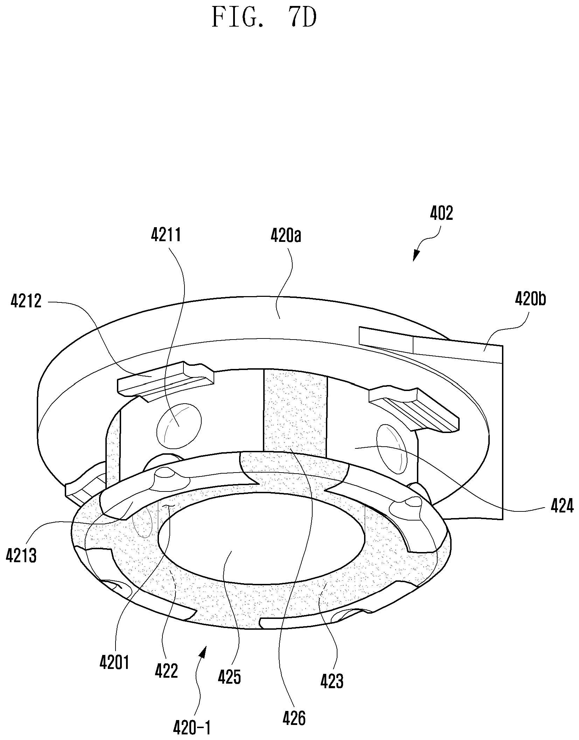

FIGS. 7C and 7D are perspective views of the second board including the connector structure according to various embodiments of the disclosure.

Referring to FIG. 7C, a non-conductive buffer member 426 filled in the space between the contact pins 421, 422, 423, and 424 of the connector structure 420-1 and the non-conductive connector body 425 may be further included. In an embodiment, the non-conductive buffer member 426 may prevent foreign substances from entering the space between the contact pins 421, 422, 423, and 424 and the non-conductive connector body 426 and elastically support the contact pins 421, 422, 423, and 424, which may help reduce damage or unintentional deformation of the contact pins 421, 422, 423, and 424.In an embodiment, the non-conductive buffer member 426 may include at least one of silicone, urethane, or rubber.

Referring to FIG. 7D, the non-conductive buffer member 426 may extend to the contact pins 421, 422, 423, and 424, as well as the space between the contact pins 421, 422, 423, and 424 and the non-conductive connector body 426.

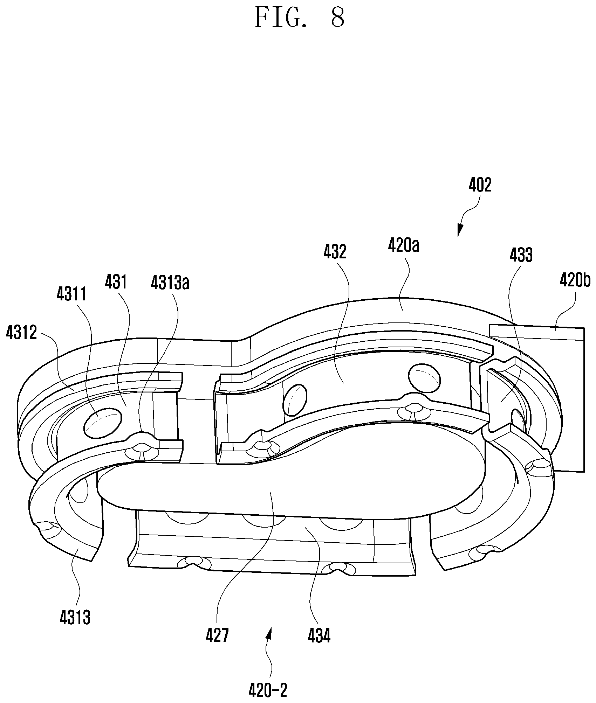

FIG. 8 is a perspective view of a second board including a connector structure according to various embodiments of the disclosure.

Referring to FIG. 8, the connector structure 420-2 may include a connector header 420a and a plurality of contact pins 431, 432, 433, and 434 arranged to protrude from the connector header 420a at a predetermined interval. In an embodiment, the plurality of contact pins 431, 432, 433, and 434 may include a first contact pin 431, a second contact pin 432, a third contact pin 433, and a fourth contact pin 434 arranged at a predetermined interval along the edge of the non-conductive connector body 427 that protrudes in an asymmetrical shape from the connector header 420a.In an embodiment, the first contact pin 431, the second contact pin 432, the third contact pin 433, and the fourth contact pin 434 may have different shapes and sizes to correspond to the shape of the asymmetrically shaped non-conductive connector body 427.

According to various embodiments, the first contact pin 431 may include a first extension pin 4312 that protrudes outward from one end and a second extension pin 4313 that protrudes outward from the other end.In an embodiment, the first contact pin 431 may include at least one elastic protrusion 4311 formed to protrude outward between the first extension pin 4312 and the second extension pin 4313.In an embodiment, the second extension pin 4313 may include at least one support protrusion 4313a protruding toward the first extension pin 4312.In an embodiment, the second to fourth contact pins 432, 433, and 434 may also be formed in substantially the same way as the first contact pin 431.In an embodiment, at least one elastic protrusion 4311 and/or at least one support protrusion 4313a may be disposed in different numbers on the first contact pin 431, the second contact pin 432, the third contact pin 433, and the fourth contact pin 434 which have different sizes.

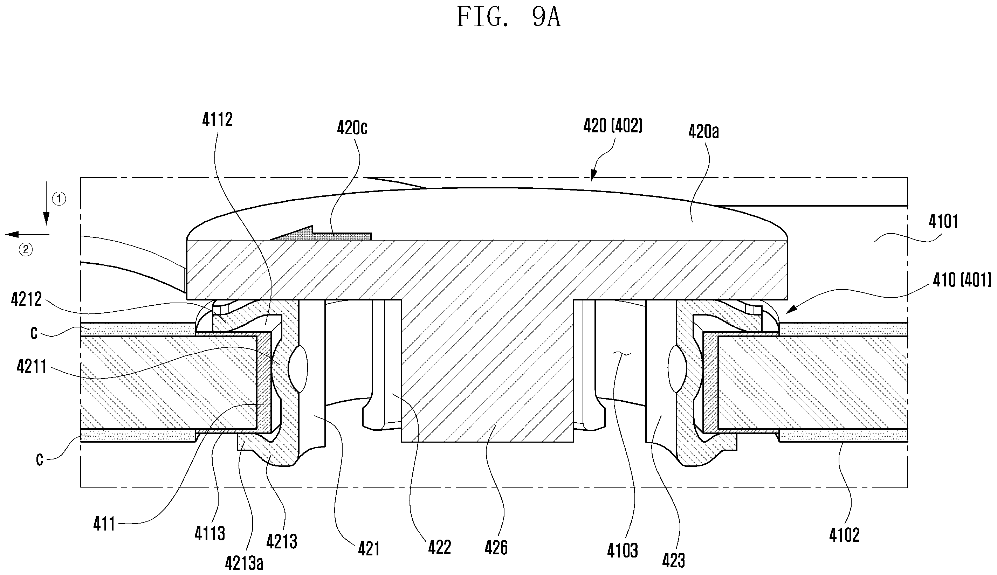

FIG. 9A is a partial cross-sectional view illustrating the state in which a connector structure is connected to a socket structure according to various embodiments of the disclosure.FIG. 9B is a side view illustrating the state in which the connector structure is connected to the socket structure according to various embodiments of the disclosure.

Referring to FIGS. 9A and 9B, the electrical connection structure may include a socket structure 410 disposed on a first board 401 and a connector structure 420 disposed on a second board 402 to be connected to the socket structure 420.In an embodiment, when the connector structure 420 is connected to socket structure 410, one or more contact pins 421, 422, and 423 may be inserted into the through hole 4103 in the first board 401 along a first direction (direction ①).In this case, even when the first extension pin 4212 comes into contact with the first extension pad 4112, the second extension pin 4213 may not come into contact with the second extension pad 4113.Then, when the connector header 420a is further pressed in the first direction (direction ①), the first extension pin 4212 is elastically deformed, and the first contact pin 421 is further inserted into the through hole 4103, whereby the second extension pin 4213 may pass through the through hole 4103 and spread outward to come into contact with the second extension pad 4113.For example, the support protrusion 4213a of the second extension pin 4213 may be in physical contact with the second extension pad 4113.The elastic deformation of the first extension pin 4212 and the second extension pin 4213 is caused since the distance between the first extension pin 4212 and the second extension pin 4213 (e.g., the distance d2 in FIG. 7B) is configured to be smaller than the vertical distance between the first extension pad 4112 and the second extension pad 4113 (e.g., the vertical distance d1 in FIG. 4B).Therefore, since the first extension pin 4212 is coupled by pressing the first extension pad 4112 in the first direction (direction ①), and the second extension pin 4213 is coupled by pressing the second extension pad 4113 in a direction opposite to the first direction (direction ①), the socket structure 420 may be provided with a fixing force (e.g., fastening force) along the first direction (direction ①).At the same time, since the elastic protrusion 4211 of the first contact pin 421 elastically presses the first conductive pad 411 of the socket structure 410, the first contact pin 421 may provide a fixing force (e.g., fastening force) in a second direction (e.g., direction ②) perpendicular to the first direction (direction ①). In an embodiment, the coupling structure of the second contact pin 422 and the second conductive pad (e.g., the second conductive pad 412 in FIG. 4A), the coupling structure of the third contact pin 423 and the third conductive pad (e.g., the third conductive pad 413 in FIG. 4A), and the coupling structure of the fourth contact pin (e.g., the fourth contact pin 424 in FIG. 7A) and the fourth conductive pad (e.g., the fourth conductive pad 414 in FIG. 4A) may also be substantially the same as that of the first contact pin 421 and the first conductive pad 411.

According to various embodiments, the support protrusion 4213a may induce formation of a separation gap d3 that partially separates the second extension pin 4213 and the second extension pad (e.g., the second extension pad 4113 in FIG. 4B), which may help easily separate the connector structure 420 connected to the socket structure 410 by a separation jig.For example, after the separation jig is partially inserted into the separation gap d3, the second extension pin 4213 is pushed into the through hole 4103 using the lever principle, which may help separate the connector structure 420 from the socket structure 410.

According to various embodiments, the connector structure 420 may further include an alignment structure 420c.For example, the alignment structure 420c may include an indicator (e.g., an identifier) displayed on the upper surface of the connector header 420a to guide correct connection when the connector structure is connected to the socket structure. In some embodiments, the alignment structure 420c may be used through at least a portion of a fixing boss hole formed between the first board 401 and a peripheral support structure (e.g., a support member).

According to exemplary embodiments of the disclosure, the electrical connection structure provides a fixing force in the horizontal direction (e.g., direction ①) and the vertical direction (e.g., direction ②) simultaneously when the connector structure 420 is connected to the socket structure 410, which may help reduce loose insertion of the connection structure 420 or damage to the connector structure 420 due to an external impact.

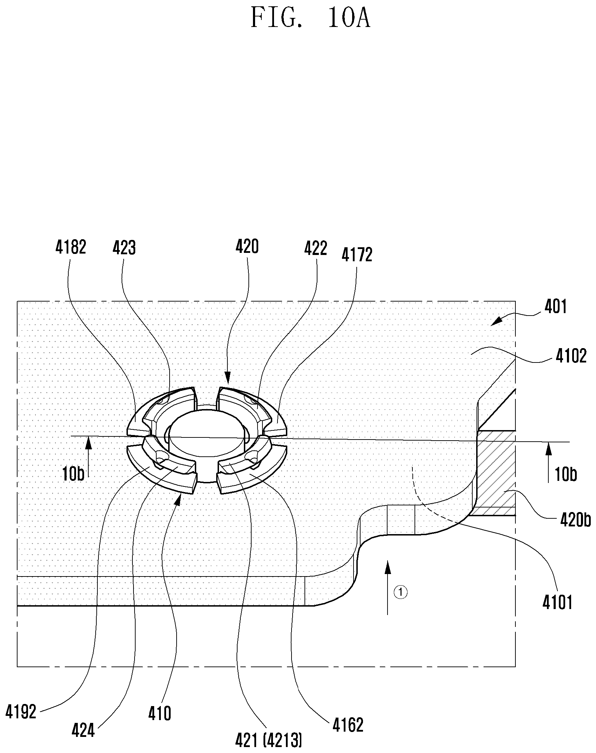

FIG. 10A is a perspective view of a connector structure connected to a socket structure according to various embodiments of the disclosure, as viewed from a second surfaceof the first board.FIG. 10B is a side view of the first board according to various embodiments of the disclosure taken along line 10b-10b in FIG. 10A.

According to various embodiments, when the support protrusion 4213a of the second extension pin 4213 and the second extension pad (e.g., the second extension pad 4113 in FIG. 4B) are in direct contact and are separated through by separation jig, the second extension pad 4113 may be damaged or a short phenomenon may occur.

Referring to FIGS. 10A and 10B, in order to prevent this problem and reinforce the rigidity around a through hole (e.g., the through hole 4103 in FIG. 4B), the socket structure 410 may further include a reinforcing member 4162 (e.g., the second reinforcing member 4162 in FIG. 5B) disposed between a second extension pad (e.g., the second extension pad 4113 in FIG. 5B) and the support protrusion 4213a of the second extension pin 4213.Accordingly, the support protrusion 4213a may induce formation of a separation gap d4 that partially separates the second extension pin 4213 and the reinforcing member 4162. This separation gap d4 may help easily separate the connector structure 420 connected to the socket structure 410 by a separation jig and reduce damage to the second extension pad 4113.In some embodiments, the socket structure 410 may further include an additional reinforcing member (e.g., the first extension pad 4112 in FIG. 5A) disposed between a first extension pad (e.g., the first extension pad 4112 in FIG. 5A) and the first extension pin 4212.

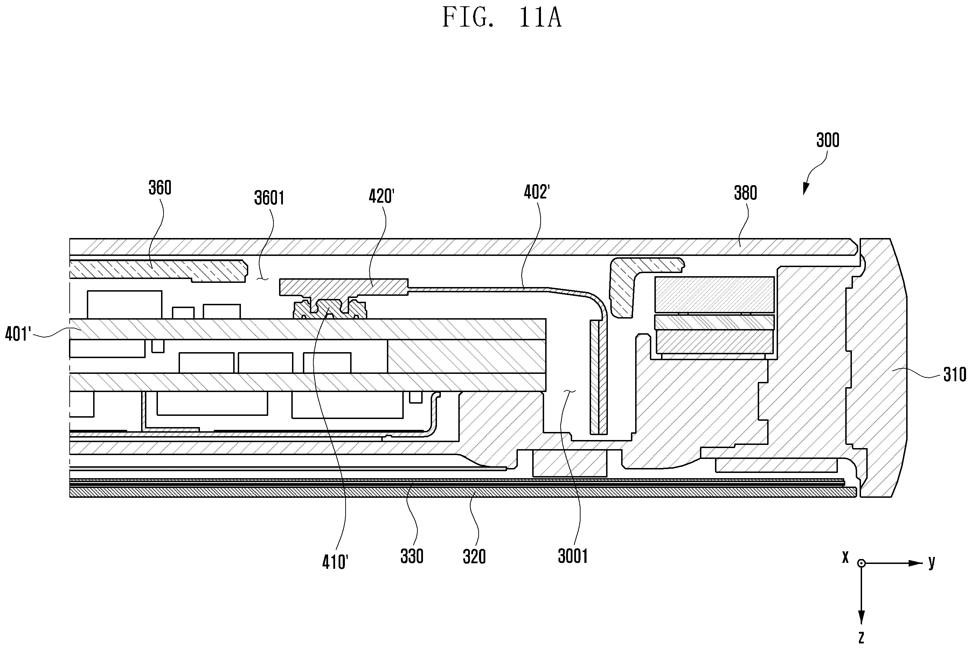

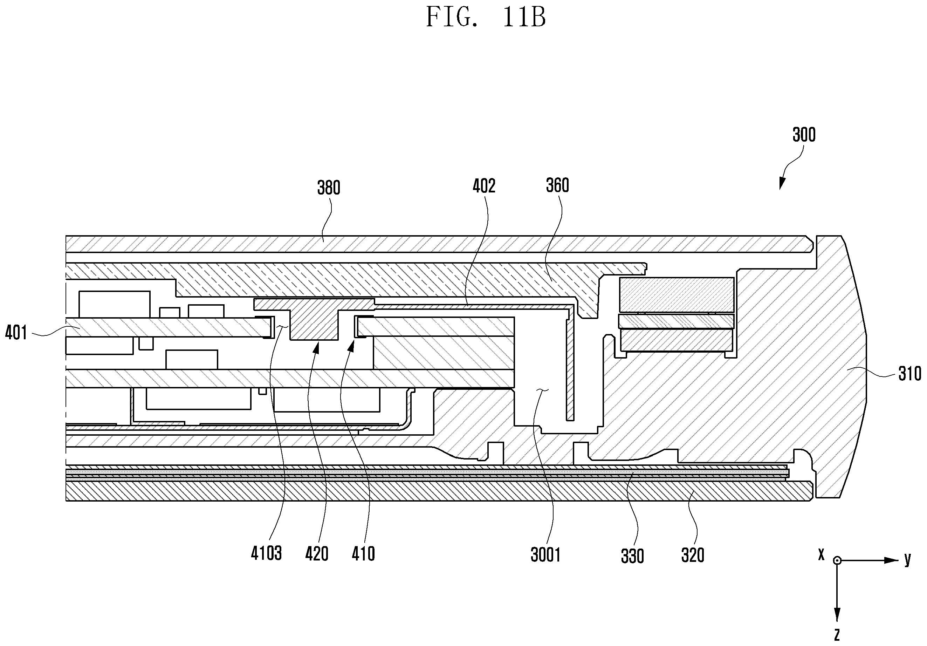

FIG. 11A is a partial cross-sectional view of an electronic device including an electrical connection structure according to a comparative example.FIG. 11B is a partial cross-sectional view of an electronic device including an electrical connection structure according to various embodiments of the disclosure.

Referring to FIGS. 11A and 11B, an electronic device 300 may include a front surface cover 320, a rear surface cover 380, and a side surface member 310 disposed to surround an inner space 3001 between the front surface cover 320 and the rear surface cover 380.In an embodiment, the electronic device 300 may include a display 330 disposed in the inner space 3001 and visible from the outside through the front surface cover 320.

As illustrated in the comparative example of FIG. 11A, the electronic device 300 may include a first board 401' disposed in the inner space 3001 and a second board 402 electrically connected to the first board 401'.In an embodiment, the first board 401' may include a socket structure 410' protruding outward, and the second board 402' may include a connector structure 420' to be connected to the socket structure 401'.For example, in the case of the comparative example, due to the heights of the socket structure 410' and the connector structure 420' connected to the socket structure 410', in order to maintain the thickness of the electronic device 300, a support member 360 (e.g., the second support member 360 in FIG. 3) disposed at the periphery may have an accommodation hole 3601 (or a recess) configured to accommodate the connector structure 420'.This accommodation hole 3601 may weaken the rigidity of the electronic device 300.In addition, when the support member 360 is not provided with the accommodation hole 3601 to maintain rigidity, the thickness of the electronic device 300 increases by the heights of the socket structure 410' and the connector structure 420' connected to the socket structure 410', which may work against slimming.

As illustrated in FIG. 11B, according to an exemplary embodiment of the disclosure, when the connector structure 420 of the second board 402 is connected by being inserted into the socket structure 410 using a through hole 4103 formed in the first board 401, there is no need to form an accommodation hole in the support member 360, which may help reinforce the rigidity and slim the electronic device 300.

According to various embodiments, an electronic device includes a first printed circuit board (e.g., the first board 401 in FIG. 4B) including at least one through hole (e.g., the through hole 4103 in FIG. 4B) and at least one conductive pad disposed on an inner surface of the through hole, a second printed circuit board (e.g., the second board 402 in FIG. 7A) disposed to be electrically connected to the first printed circuit board, and a connector structure (e.g., the connector structure 420 in FIG. 7A) disposed to electrically interconnect the first printed circuit board and the second printed circuit board. The connector structure includes a connector header 420a, a connector body (e.g., the non-conductive connector body 425 in FIG. 7A) extending from the connector header and inserted into the through hole of the first printed circuit board, and at least one contact pin (e.g., the first contact pin 421 in FIG. 7A) disposed on the connector header. The at least one contact pin is configured to be electrically connected to the at least one conductive pad when the connector structure is inserted into the first printed circuit board. The structure according to the present invention may reinforce the rigidity and slim the electronic device.

According to various embodiments, the at least one conductive pad may include a plurality of conductive pads (e.g., the first to fourth conductive pads 411, 412, 413, and 414 in FIG. 4B) arranged at a predetermined interval along an inner surface of the through hole, and the at least one contact pin may include a plurality of contact pins (e.g., the first to fourth contact pins 421, 422, 423, and 424 in FIG. 7A) extending from the connector header to correspond to the plurality of conductive pads, respectively.

According to various embodiments, the plurality of contact pins may be arranged to surround the connector body to correspond to the shape of the through hole.

According to various embodiments, the electronic device may further include a non-conductive buffer member (e.g., the buffer member 426 in FIG. 7C) filled between the plurality of contact pins and the connector body.

According to various embodiments, the non-conductive buffer member may be made of at least one of silicone, urethane, and rubber.

According to various embodiments, the at least one contact pin may include at least one elastic protrusion (e.g., the elastic protrusion 4211 in FIG. 7A) configured to elastically press the at least one conductive pad when the connector structure is inserted into the first printed circuit board.

According to various embodiments, when the connector structure is inserted into the first printed circuit board, the at least one contact pin may be disposed to penetrate the through hole.

According to various embodiments, the first printed circuit board may include a first surface and a second surface oriented in a direction opposite to the first surface, and the at least one conductive pad may include a first extension pad (e.g., the first extension pad 4112 in FIG. 4B) extending to at least a portion of the first surface.

According to various embodiments, the contact pin may include a first extension pin (e.g., the first extension pin 4212 in FIG. 7A) which is brought into elastic contact with the first extension pad when the connector structure is connected to the socket structure.

According to various embodiments, the at least one conductive pad may include a second extension pad (e.g., the second extension pad 4113 in FIG. 4B) extending to at least a portion of the second surface.

According to various embodiments, the at least one contact pin may include a second extension pin (e.g., the second extension pin 4213 in FIG. 7A) which is brought into elastic contact with the second extension pad when the connector structure is inserted into the first printed circuit board.

According to various embodiments, the electronic device may further include a first reinforcing member (e.g., the first reinforcing member 4161 in FIG. 5B) disposed on the first extension pad.

According to various embodiments, the electronic device may further include a cover layer (e.g., the cover layer c in FIG. 5B) disposed between the first reinforcing member and the through hole when the first surface is viewed from above.

According to various embodiments, the cover layer may include a solder resist layer provided on the first surface of the first printed circuit board.

According to various embodiments, the electronic device may further include a second reinforcing member (e.g., the second reinforcing member 4162 in FIG. 5B) disposed on the second extension pad.

According to various embodiments, the second extension pin may include a support protrusion (e.g., the support protrusion 4213a in FIG. 7A) that protrudes to come into contact with the second reinforcement member.

According to various embodiments, the support protrusion may form a separation gap (e.g., the separation gap d4 in FIG. 10B) that partially separates the second extension pin and the second reinforcing member.

According to various embodiments, the electrical connection structure may include a socket structure (e.g., the socket structure 410 in FIG. 4B) disposed on a board (e.g., the first board 401 in FIG. 4B) including a first surface (e.g., the first surface 4101 in FIG. 4B) and a second surface (e.g., the second surface 4102 in FIG. 4B) oriented in an opposite direction to the first surface, and a connector structure (e.g., the connector structure 420 in FIG. 7A) to be connected to the socket structure. The socket structure may include a through hole (e.g., the through hole 4103 in FIG. 4B) extending from the first surface to the second surface and at least one conductive pad (e.g., the first conductive pad 411 in FIG. 4B) disposed on the inner surface of the through hole.The connector structure may include a connector header (e.g., the connector header 420a in FIG. 7A) and at least one contact pin (e.g., the first contact pin 421 in FIG. 7A) extending from the connector header and having a shape corresponding to that of the at least one conductive pad.When the connector structure is connected to the socket structure, the at least one contact pin may be brought into elastic contact with the at least one conductive pad.

According to various embodiments, the at least one conductive pad may include a plurality of conductive pads arranged at a predetermined interval along the inner surface of the through hole, and the at least one contact pin may include a plurality of contact pins extending from the connector header to correspond to the plurality of conductive pads, respectively.

According to various embodiments, the at least one contact pin may include at least one elastic protrusion configured to elastically press the at least one conductive pad when the connector structure is connected to the socket structure.

The embodiments of the disclosure disclosed in this specification and drawings are provided merely to propose specific examples in order to easily describe the technical features according to the embodiments of the disclosure and to help understanding of the embodiments of the disclosure, and are not intended to limit the scope of the embodiments of the disclosure.Accordingly, the scope of various embodiments of the disclosure is to be construed as including all changes or modifications within the scope of the appended claims.

## Claims

1. An electronic device (300) comprising:
a first printed circuit board (401) comprising at least one through hole (4103) and at least one conductive pad (411) disposed on an inner surface of the through hole (4103);
a second printed circuit board (402) disposed to be electrically connected to the first printed circuit board (401), the second printed circuit board (402) at least partially overlapping the first printed circuit board (401) when a surface of the first printed circuit board (401) is viewed from above; and
a connector structure (420) disposed on the second printed circuit board (402), to electrically interconnect the first printed circuit board (401) and the second printed circuit board (402),
wherein the connector structure (420) comprises:
a connector header (420a);
a connector body (425) extending from the connector header (420a) and inserted into the through hole (4103) of the first printed circuit board (401); and
at least one contact pin (421) disposed on the connector header (420a), and
wherein the at least one contact pin (421) is configured to be electrically connected to the at least one conductive pad (411) when the connector structure (420) is inserted into the first printed circuit board (401).

2. The electronic device (300) of claim 1, wherein the at least one conductive pad (411) comprises a plurality of conductive pads (411, 412, 413, 414) arranged at a predetermined interval along an inner surface of the through hole (4103), and/or
wherein the at least one contact pin (421) comprises a plurality of contact pins (421, 422, 423, 424) extending from the connector header (420a) to correspond to the plurality of conductive pads (411, 412, 413, 414), respectively.

3. The electronic device (300) of claim 2, wherein the plurality of contact pins (421, 422, 423, 424) are arranged to surround the connector body (425) to correspond to a shape of the through hole (4103).

4. The electronic device (300) of claim 2 or 3, further comprising:
a non-conductive buffer member (426) filled between the plurality of contact pins (421, 422, 423, 424) and the connector body (425).

5. The electronic device (300) of claim 4, wherein the non-conductive buffer member (426) is made of at least one of silicone, urethane, and rubber.

6. The electronic device (300) of one of claims 1 to 5, wherein the at least one contact pin (421) comprises at least one elastic protrusion (4211) configured to elastically press the at least one conductive pad (411) when the connector structure (420) is inserted into the first printed circuit board (401).

7. The electronic device (300) of one of claims 1 to 6, wherein, when the connector structure (420) is inserted into the first printed circuit board (401), the at least one contact pin (421) is disposed to penetrate the through hole (4103).

8. The electronic device (300) of one of claims 1 to 7, wherein the first printed circuit board (401) comprises a first surface (4101) and a second surface (4102) oriented in a direction opposite to the first surface (4101), and/or
wherein the at least one conductive pad (411) comprises a first extension pad (4112) extending to at least a portion of the first surface (4101).

9. The electronic device (300) of claim 8, wherein the at least one contact pin (421) comprises a first extension pin (4212) which is brought into elastic contact with the first extension pad (4112) when the connector structure (420) is connected to the first printed circuit board (401).

10. The electronic device (300) of claim 8 or 9, wherein the at least one conductive pad (411) comprises a second extension pad (4113) extending to at least a portion of the second surface (4102).

11. The electronic device (300) of claim 10, wherein the at least one contact pin (421) comprises a second extension pin (4213) which is brought into elastic contact with the second extension pad (4113) when the connector structure (420) is inserted into the first printed circuit board (401).

12. The electronic device (300) of one of claims 8 to 11, further comprising:
a first reinforcing member (4161) disposed on the first extension pad (4112).

13. The electronic device (300) of claim 12, further comprising:
a cover layer (c) disposed between the first reinforcing member (4161) and the through hole (4103) when the first surface (4101) is viewed from above.

14. The electronic device (300) of claim 13, wherein the cover layer (c) comprises a solder resist layer provided on the first surface (4101) of the first printed circuit board (401).

15. The electronic device (300) of one of claims 8 to 14, further comprising:
a second reinforcing member (4162) disposed on the second extension pad (4113).

## Patentansprüche

1. Elektronische Vorrichtung (300), umfassend:
eine erste Leiterplatte (401) mit mindestens einem Durchgangsloch (4103) und mindestens einem leitfähigen Pad (411), das auf einer Innenfläche des Durchgangslochs (4103) angeordnet ist;
eine zweite Leiterplatte (402), die so angeordnet ist, dass sie elektrisch mit der ersten Leiterplatte (401) verbunden ist, wobei die zweite Leiterplatte (402) die erste Leiterplatte (401) zumindest teilweise überlappt, wenn eine Oberfläche der ersten Leiterplatte (401) von oben betrachtet wird; und
eine Verbinderstruktur (420), die auf der zweiten Leiterplatte (402) angeordnet ist, um die erste Leiterplatte (401) und die zweite Leiterplatte (402) elektrisch miteinander zu verbinden,
wobei die Verbinderstruktur (420) Folgendes umfasst:
einen Verbinderkopf (420a);
einen Verbinderkörper (425), der sich vom Verbinderkopf (420a) erstreckt und in das Durchgangsloch (4103) der ersten Leiterplatte (401) eingeführt ist; und
mindestens einen Kontaktstift (421), der an dem Verbinderkopf (420a) angeordnet ist, und
wobei der mindestens eine Kontaktstift (421) so konfiguriert ist, dass er elektrisch mit dem mindestens einen leitfähigen Pad (411) verbunden wird, wenn die Verbinderstruktur (420) in die erste Leiterplatte (401) eingesetzt wird.

2. Elektronische Vorrichtung (300) nach Anspruch 1, wobei das mindestens eine leitfähige Pad (411) eine Vielzahl von leitfähigen Pads (411, 412, 413, 414) umfasst, die in einem vorbestimmten Abstand entlang einer Innenfläche des Durchgangslochs (4103) angeordnet sind, und/oder
wobei der mindestens eine Kontaktstift (421) eine Vielzahl von Kontaktstiften (421, 422, 423, 424) umfasst, die sich vom Verbinderkopf (420a) erstrecken, um jeweils der Vielzahl von leitfähigen Pads (411, 412, 413, 414) zu entsprechen.

3. Elektronische Vorrichtung (300) nach Anspruch 2, wobei die Vielzahl von Kontaktstiften (421, 422, 423, 424) so angeordnet sind, dass sie den Verbinderkörper (425) umgeben, um einer Form des Durchgangslochs (4103) zu entsprechen.

4. Elektronische Vorrichtung (300) nach Anspruch 2 oder 3, umfassend ferner:
ein nichtleitendes Pufferelement (426), das zwischen der Vielzahl von Kontaktstiften (421, 422, 423, 424) und dem Verbinderkörper (425) eingefüllt ist.

5. Elektronische Vorrichtung (300) nach Anspruch 4, wobei das nichtleitende Pufferelement (426) aus mindestens einem von Silikon, Urethan und Gummi besteht.

6. Elektronische Vorrichtung (300) nach einem der Ansprüche 1 bis 5, wobei der mindestens eine Kontaktstift (421) mindestens einen elastischen Vorsprung (4211) umfasst, der so konfiguriert ist, dass er das mindestens eine leitfähige Pad (411) elastisch andrückt, wenn die Verbinderstruktur (420) in die erste Leiterplatte (401) eingesetzt wird.

7. Elektronische Vorrichtung (300) nach einem der Ansprüche 1 bis 6, wobei der mindestens eine Kontaktstift (421) so angeordnet ist, dass er das Durchgangsloch (4103) durchdringt, wenn die Verbinderstruktur (420) in die erste Leiterplatte (401) eingesetzt wird.

8. Elektronische Vorrichtung (300) nach einem der Ansprüche 1 bis 7, wobei die erste Leiterplatte (401) eine erste Oberfläche (4101) und eine zweite Oberfläche (4102), die in einer zur ersten Oberfläche (4101) entgegengesetzten Richtung ausgerichtet ist, umfasst, und/oder
wobei das mindestens eine leitfähige Pad (411) ein erstes Verlängerungspad (4112) umfasst, das sich bis zu mindestens einem Abschnitt der ersten Oberfläche (4101) erstreckt.

9. Elektronische Vorrichtung (300) nach Anspruch 8, wobei der mindestens eine Kontaktstift (421) einen ersten Verlängerungsstift (4212) umfasst, der in elastischen Kontakt mit dem ersten Verlängerungspad (4112) gebracht wird, wenn die Verbinderstruktur (420) mit der ersten Leiterplatte (401) verbunden wird.

10. Elektronische Vorrichtung (300) nach Anspruch 8 oder 9, wobei das mindestens eine leitfähige Pad (411) ein zweites Verlängerungspad (4113) umfasst, das sich bis zu mindestens einem Abschnitt der zweiten Oberfläche (4102) erstreckt.

11. Elektronische Vorrichtung (300) nach Anspruch 10, wobei der mindestens eine Kontaktstift (421) einen zweiten Verlängerungsstift (4213) umfasst, der in elastischen Kontakt mit dem zweiten Verlängerungspad (4113) gebracht wird, wenn die Verbinderstruktur (420) in die erste Leiterplatte (401) eingesetzt wird.

12. Elektronische Vorrichtung (300) nach einem der Ansprüche 8 bis 11, umfassend ferner:
ein erstes Verstärkungselement (4161), das auf dem ersten Verlängerungspad (4112) angeordnet ist.

13. Elektronische Vorrichtung (300) nach Anspruch 12, umfassend ferner:
eine Deckschicht (c), die zwischen dem ersten Verstärkungselement (4161) und dem Durchgangsloch (4103) angeordnet ist, wenn die erste Oberfläche (4101) von oben betrachtet wird.

14. Elektronische Vorrichtung (300) nach Anspruch 13, wobei die Deckschicht (c) eine Lötstopplackschicht umfasst, die auf der ersten Oberfläche (4101) der ersten Leiterplatte (401) vorgesehen ist.

15. Elektronische Vorrichtung (300) nach einem der Ansprüche 8 bis 14, umfassend ferner:
ein zweites Verstärkungselement (4162), das auf dem zweiten Verlängerungspad (4113) angeordnet ist.

## Revendications

1. Dispositif électronique (300) comprenant :
une première carte de circuit imprimé (401) comprenant au moins un trou traversant (4103) et au moins un plot conducteur (411) disposé sur une surface interne du trou traversant (4103) ;
une seconde carte de circuit imprimé (402) disposée pour être connectée électriquement à la première carte de circuit imprimé (401), la seconde carte de circuit imprimé (402) chevauchant au moins partiellement la première carte de circuit imprimé (401) lorsqu'une surface de la première carte de circuit imprimé (401) est observée de dessus ; et
une structure de connecteur (420) disposée sur la seconde carte de circuit imprimé (402), pour interconnecter électriquement la première carte de circuit imprimé (401) et la seconde carte de circuit imprimé (402),
dans lequel la structure de connecteur (420) comprend :
une embase de connecteur (420a) ;
un corps de connecteur (425) s'étendant depuis l'embase de connecteur (420a) et inséré dans le trou traversant (4103) de la première carte de circuit imprimé (401) ; et
au moins une broche de contact (421) disposée sur l'embase de connecteur (420a), et
dans lequel ladite au moins une broche de contact (421) est configurée pour être connectée électriquement audit au moins un plot conducteur (411) lorsque la structure de connecteur (420) est insérée dans la première carte de circuit imprimé (401).

2. Dispositif électronique (300) selon la revendication 1, dans lequel ledit au moins un plot conducteur (411) comprend une pluralité de plots conducteurs (411, 412, 413, 414) agencés à un intervalle prédéterminé le long d'une surface interne du trou traversant (4103), et/ou
dans lequel ladite au moins une broche de contact (421) comprend une pluralité de broches de contact (421, 422, 423, 424) s'étendant depuis l'embase de connecteur (420a) pour correspondre respectivement à la pluralité de plots conducteurs (411, 412, 413, 414).

3. Dispositif électronique (300) selon la revendication 2, dans lequel la pluralité de broches de contact (421, 422, 423, 424) est agencée pour entourer le corps de connecteur (425) afin de correspondre à une forme du trou traversant (4103).

4. Dispositif électronique (300) selon la revendication 2 ou 3, comprenant en outre :
un élément tampon non conducteur (426) interposé entre la pluralité de broches de contact (421, 422, 423, 424) et le corps de connecteur (425).

5. Dispositif électronique (300) selon la revendication 4, dans lequel l'élément tampon non conducteur (426) est constitué d'au moins un élément parmi le silicone, l'uréthane et le caoutchouc.

6. Dispositif électronique (300) selon l'une des revendications 1 à 5, dans lequel ladite au moins une broche de contact (421) comprend au moins une saillie élastique (4211) configurée pour appuyer élastiquement contre ledit au moins un plot conducteur (411) lorsque la structure de connecteur (420) est insérée dans la première carte de circuit imprimé (401).

7. Dispositif électronique (300) selon l'une des revendications 1 à 6, dans lequel, lorsque la structure de connecteur (420) est insérée dans la première carte de circuit imprimé (401), ladite au moins une broche de contact (421) est disposée pour pénétrer dans le trou traversant (4103).

8. Dispositif électronique (300) selon l'une des revendications 1 à 7, dans lequel la première carte de circuit imprimé (401) comprend une première surface (4101) et une seconde surface (4102) orientée dans une direction opposée à la première surface (4101), et/ou
dans lequel ledit au moins un plot conducteur (411) comprend un premier plot de prolongement (4112) s'étendant vers au moins une partie de la première surface (4101).

9. Dispositif électronique (300) selon la revendication 8, dans lequel ladite au moins une broche de contact (421) comprend une première broche de prolongement (4212) qui est amenée en contact élastique avec le premier plot de prolongement (4112) lorsque la structure de connecteur (420) est connectée à la première carte de circuit imprimé (401).

10. Dispositif électronique (300) selon la revendication 8 ou 9, dans lequel ledit au moins un plot conducteur (411) comprend un second plot de prolongement (4113) s'étendant vers au moins une partie de la seconde surface (4102).

11. Dispositif électronique (300) selon la revendication 10, dans lequel ladite au moins une broche de contact (421) comprend une seconde broche de prolongement (4213) qui est amenée en contact élastique avec le second plot de prolongement (4113) lorsque la structure de connecteur (420) est insérée dans la première carte de circuit imprimé (401).

12. Dispositif électronique (300) selon l'une des revendications 8 à 11, comprenant en outre :
un premier élément de renfort (4161) disposé sur le premier plot de prolongement (4112).

13. Dispositif électronique (300) selon la revendication 12, comprenant en outre :
une couche de couverture (c) disposée entre le premier élément de renfort (4161) et le trou traversant (4103) lorsque la première surface (4101) est observée de dessus.

14. Dispositif électronique (300) selon la revendication 13, dans lequel la couche de couverture (c) comprend une couche de vernis épargne prévue sur la première surface (4101) de la première carte de circuit imprimé (401).

15. Dispositif électronique (300) selon l'une des revendications 8 à 14, comprenant en outre :
un second élément de renfort (4162) disposé sur le second plot de prolongement (4113).
